# EUROPEAN PATENT SPECIFICATION

(11) **EP 2 535 555 B1**
(45) Date of publication and mention of the grant of the patent: **17.09.2014**
(21) Application number: 12171770.6
(22) Date of filing: 13.06.2012
(51) Int. Cl.: F02N 3/04, F02N 11/00, G01R 19/165, G01R 31/36

(54) **Straddle type vehicle**
Grätschsitzfahrzeug
Véhicule de type à enfourcher

(30) Priority: 13.06.2011 JP 2011131409
(43) Date of publication of application: 19.12.2012
(73) Proprietor: Yamaha Hatsudoki Kabushiki Kaisha, Shizuoka-ken Shizuoka 438-8501 (JP)
(72) Inventor: Matsuda, Takeshi, Iwata-shi, Shizuoka 438-8501 (JP); Kimura, Junichi, Iwata-shi, Shizuoka 438-8501 (JP); Ubukata, Katsunori, Iwata-shi, Shizuoka 438-8501 (JP)
(74) Representative: Grünecker, Kinkeldey, Stockmair & Schwanhäusser

(56) References cited:
- EP-A2- 0 916 959
- DE-A1- 10 261 491
- DE-A1-102004 025 240
- US-A- 6 091 325

## Description

### BACKGROUND OF THE INVENTION

### Field of the Invention

The present invention relates to straddle type vehicles, and more particularly, to straddle type vehicles in which electric power is supplied from a battery to an engine control system.

### Description of the Background Art

Motorcycles, which are a type of straddle type vehicles, are known. Some motorcycles include an engine control system for controlling the engine. The engine control system includes, for example, a fuel tank, a fuel pump and an injector. The engine control system is supplied with electric power from the battery and drives the fuel pump and other units. The power supply from the battery is controlled by the engine control unit (ECU). When the battery level falls due to power consumption or deterioration of the battery, the engine cannot be driven. To avoid a situation where the engine cannot be driven, a motorcycle has been proposed that includes a warning device that determines whether the battery level is sufficient or not and, if not, issues a warning (see JP2000-190793A).

In the motorcycle described in JP2000-190793A, the engine control unit includes a detection part that senses the battery level. In the motorcycle described in JP2000-190793A, electric power is supplied to the detection part and, if the determined battery level is lower than a predetermined value, a warning is issued. The detection part has a voltage divider resistor. During sensing, the voltage at an intermediate point of the voltage divider resistor (i.e. a quarter voltage divider point) is determined.

A motorcycle described in JP2000-190793A must include a detection part intended to determine the battery level, leading to higher costs. A motorcycle described in JP2000-190793A must include a space for the detection part.

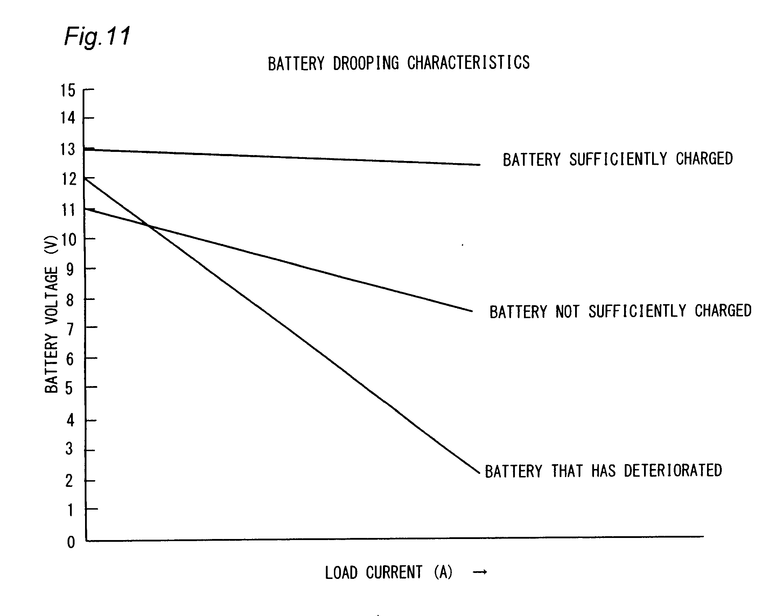

FIG. 11 is a graph illustrating drooping characteristics of batteries. In FIG. 11, the vertical axis represents the battery voltage, while the horizontal axis represents the load current. As shown in FIG. 11, if a battery is sufficiently charged and has not deteriorated, the battery voltage decreases by only small amounts even with increased load current. However, if a battery is not sufficiently charged, the battery voltage decreases more rapidly with increased load current than is the case when the battery is sufficiently charged. If a battery has deteriorated, the battery voltage decreases rapidly with increased load current even when the battery is sufficiently charged. In the example of FIG. 11, with a relatively small load current, such a battery has a higher voltage than an insufficiently charged battery does; with a larger load current, it has a lower battery voltage than an insufficiently charged battery does.

As such, a battery voltage found when the load current is relatively small, such as when electric power is supplied only to the engine control unit or when electric power is supplied only to the detection part for sensing the battery level, may be different from battery voltages found when electric power is supplied to a unit with a larger load, such as a fuel pump or an ignition coil.

Further, the amount of electric power needed to start the fuel pump or other units included in the engine control system varies depending on environmental conditions around the motorcycle, such as temperature, individual specificity and secular changes. However, the arrangement of JP2000-190793A relies on the voltage value at an intermediate point of the voltage divider resistor and does not take into account environmental conditions around the motorcycle.

DE 10 2004 025240 A1 discloses a vehicle having an engine which can be started either by a starter motor supplied with electric power from a battery, or by a kick-starter. During an engine start operation in which the starter motor is supplied with electric power from the battery, a battery voltage (U Bat) is detected during said engine start operation, and said engine start operation is aborted by switching off the electric power to the starter motor if it is determined that the battery voltage (U Bat) fulfils certain criteria.

An object of the present invention is to provide an apparatus that determines whether the engine can be driven or not in a condition similar to that of an engine start without providing a detection part intended to determine the battery level.

Such an object is achieved by a straddle type vehicle in accordance with claim 1.

### DISCLOSURE OF THE INVENTION

A straddle type vehicle according to the present invention includes: an engine; an engine control system that drives the engine; a battery that supplies electric power to the engine control system; a main switch that switches between a supply enable state in which electric power can be supplied from the battery to the engine control system and a shutoff state in which power supply from the battery to the engine control system is shut off; a warning unit; and a control unit. The engine control system includes: a fuel tank; an engine drive member used for driving the engine; and an injector that supplies the fuel discharged by the engine drive member to the engine. The control unit includes: a switch detector that detects that the main switch has changed from off to on; a drive controller that drives the engine drive member when the switch detector detects that the main switch has changed from off to on; a start detector that detects a start of the engine; a voltage detector that senses a voltage at the battery after the engine drive member begins to be driven and before an engine start operation. in which electric power is supplied to the injector, is performed and the start detector detects a start of
the engine; and a warning controller that provides the warning unit with a warning instruction if a voltage value sensed by the voltage detector is not larger than a predetermined threshold.

In the straddle type vehicle described above, the engine drive member included in the engine control system also serves as a detection part for determining whether the engine can be started. Thus, in the straddle type vehicle described above, no special detection part for determining whether the engine can be started need be provided as a separate part.

In the straddle type vehicle described above, it can be determined whether the engine can be driven in a condition more similar to that of an engine start than is the case when electric power is supplied to a unit separate from the engine control system and the voltage value is measured, in order to determine whether a warning should be issued based on a voltage value after electric power begins to be supplied to the engine drive member.

### BRIEF DESCRIPTION OF THE DRAWINGS

FIG. 1 is a left side view of an entire motorcycle according to an embodiment of the present invention.
FIG. 2 is an external view of the rear face of the front cover.
FIG. 3 is an external view of the rear face of the handlebars.
FIG. 4 is a schematic view of the engine and the engine control system.
FIG. 5 is a circuit diagram showing the configuration of the engine control system.
FIG. 6 is a chart illustrating battery voltage during a motorcycle run and during an engine start, as well as the timing for battery voltage measurement.
FIG. 7 is a diagram showing results of experiments in which it was determined whether the engine was successfully started.
FIG. 8 is a flow chart illustrating a start operation for the engine.
FIG. 9 is a timing chart illustrating the driving of the ECU and the engine control system.
FIG. 10 is a timing chart illustrating the driving of the ECU and the engine control system according to another embodiment.
FIG. 11 is a diagram illustrating drooping characteristics of batteries.

### DETAILED DESCRIPTION OF THE PREFERRED EMBODIMENTS

When the voltage at the battery decreases below a predetermined value, the engine of the motorcycle cannot be started. To prevent a situation where the engine cannot be started, JP2000-190793A provides for a detection part for sensing the battery level and issuing a warning when the battery level falls below a predetermined threshold.

However, providing a detection part as in the arrangement of JP2000-190793A leads to increased manufacturing costs, and requires a space in which to provide the detection part.

The amount of electric power needed to drive an engine drive member such as a fuel pump or other units included in the engine control system varies depending on environmental conditions around the motorcycle, such as temperature, individual specificity and secular changes. However, the arrangement of JP2000-190793A relies on the voltage at an intermediate point of a voltage divider resistor, and thus does not take into account environmental conditions around the motorcycle.

The inventors of the present application paid particular attention to the fact that electric power is supplied to the engine drive member to prepare for a start of the engine before the engine is started, i.e. when the main switch changes from off to on.

It occurred to the inventors of the present application to determine the battery voltage after electric power begins to be supplied to the engine drive member included in the engine control system when an engine start is being prepared for, and determine whether the engine can be started based on the determined value of battery voltage. Thus, a detection part for sensing the battery level need not be provided, avoiding an increase in costs.

For example, to start the engine by means of a starter motor in an environment of low temperature around the motorcycle, a higher battery voltage is needed than is the case when the engine is started by a starter motor in an environment of high temperature around the motorcycle. To drive the engine drive member in an environment of low temperature around the motorcycle, the frictional resistance found when the engine drive member is driven is larger than is the case when the engine drive member is driven in an environment of high temperature around the motorcycle, requiring a higher battery voltage. In other words, both the engine and the engine drive member require higher battery voltages so that they can be driven when the surrounding temperature is low. In the arrangement of the present invention, electric power is supplied to the engine drive member, which is driven during a start of the engine, and the battery voltage is determined. Thus, it can be determined whether the engine can be started in a condition similar to that of a start of the engine.

Now, a motorcycle 10 according to an embodiment of the present invention will be described with reference to the drawings. In the embodiments below, to describe the motorcycle 10, a scooter type motorcycle is taken as an example. The same or corresponding parts in the drawings will be labeled with the same characters and their description will not be repeated.

### [First Embodiment]

### <Overall Arrangement>

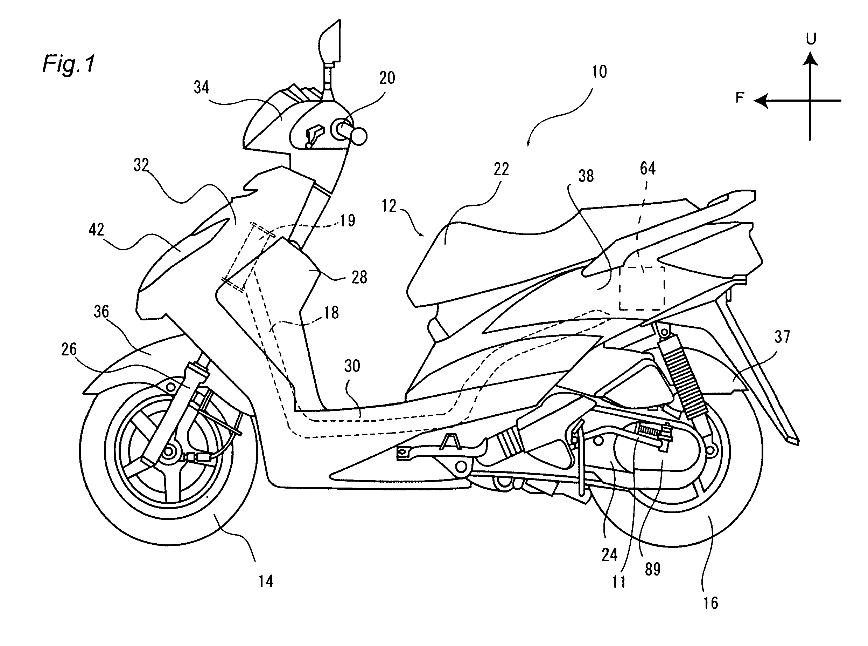

FIG. 1 shows an entire left side view of a motorcycle 10 according to the present invention. In the following description, the directions "front/forward", "rear(ward)", "left" and "right" mean directions as perceived by a rider sitting on the seat 22 of the motorcycle 10, as described below. In the drawings, the arrow "F" indicates the forward direction with respect to the motorcycle 10, the arrow "U" indicates the upward direction with respect to the motorcycle 10, and the arrow "L" indicates the left direction with respect to the motorcycle 10.

The motorcycle 10 includes a vehicle body 12, a front wheel 14 provided at the front of the motorcycle 10, a rear wheel 16 provided at the rear of the motorcycle 10, and a kick pedal 11.

The vehicle body 12 generally includes a body frame 18, handlebars 20, a seat 22 and a power unit 24.

The body frame 18 supports the power unit 24, the seat 22 and other units. The power unit 24 includes an engine 44 and a drive system. In FIG. 1, the body frame 18 is indicated by broken lines. The body frame 18 includes a head pipe 19. A steering shaft is rotatably inserted into the head pipe 19. The handlebars 20 are attached to the top end of the steering shaft. A front fork 26 is attached to the steering shaft via a bracket, not shown. The front wheel 14 is rotatably attached to the bottom end of the front fork 26. The body frame 18 is made of a metal that has high rigidity, such as steel.

The body frame 18 is covered with a body cover 28. The body cover 28 is made of resin. The body cover 28 includes a footboard 30, a front cover 32, a handle cover 34, a front fender 36, a rear fender 37 and side covers 38.

The footboard 30 is provided below the seat 22. The footboard 30 extends in the forward and rearward directions.

The front cover 32 is located forward of the seat 22. The front cover 32 is provided to cover the head pipe 19. A head light 42 is disposed on the front cover 32.

The handle cover 34 covers part of the handlebars 20. The handle cover 34 is provided above the front cover 32.

The front fender 36 is disposed above the front wheel 14. The front fender 36 is disposed below the front cover 32. The front fender 36 projects forward of the front cover 32. The rear fender 37 is disposed above the rear wheel 16.

The side covers 38 are provided below the seat 22. The side covers 38 are located above the wheel 16. The side covers 38 extend rearward from below the seat 22.

The handlebars 20 are disposed in front of the rider sitting on the seat 22. The handlebars 20 extend to the left and right. A grip that can be grasped by the rider is disposed on each end of the handlebars 20.

The seat 22 is disposed above the power unit 24. A storage space that can store an object such as a helmet is disposed below the seat 22.

The power unit 24 is disposed in the vicinity of the rear wheel 16. A CVT case 89, included in the power unit 24, is not covered with the body cover 28.

The kick pedal 11 is disposed on a side of the power unit 24. The kick pedal 11 is connected with the power unit 24. The kick pedal 11 is disposed below the seat 22.

### <Configuration of Rear Face of Front Cover >

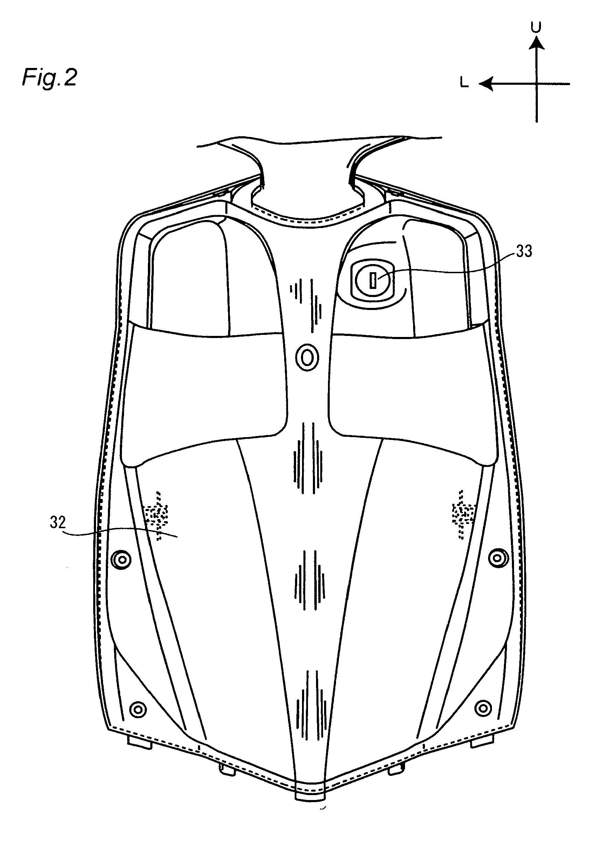

FIG. 2 is a view of the rear face of the front cover 32.

An insertion slot 33 for an ignition key for starting the motorcycle 10 is provided on the rear face of the front cover 32.

That is, the insertion slot 33 is disposed on the rear face of the front cover 32. The insertion slot 33 is disposed at an upper portion of the front cover 32.

### <Configuration of Handlebars and Handle Cover>

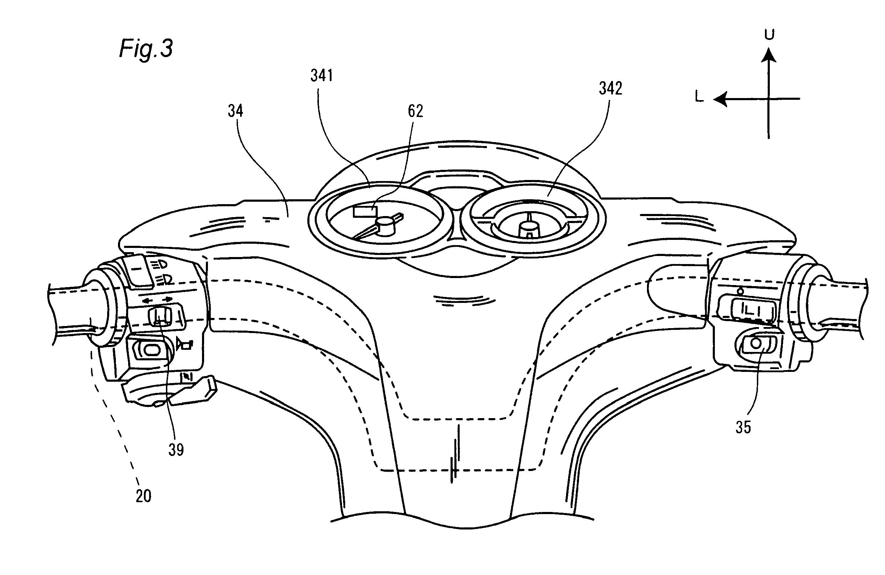

FIG. 3 is an external view of the handlebars 20 and the handle cover 3.1. as viewed from the rear and from above.

A speedometer 341 and an engine revolution counter 342 are attached to the handle cover 34.

The speedometer 341 displays the current speed. The engine revolution counter 342 displays the rotation speed of the engine. A warning lamp 62 is disposed on the speedometer 341. Although the warning lamp 62 is disposed on the speedometer 341 in the present embodiment, it may be disposed in other locations, such as on the engine revolution counter 342.

A starter button 35 is disposed on the right end of the handle cover 34. A winker switch 39 is disposed on the left end of the handle cover 34.

The starter button 35 causes the engine 44 to start. The winker switch 39 causes the one of the winkers that indicates the direction in which the rider wishes to advance to light up.

### <Configuration of Engine and System for Driving Engine>

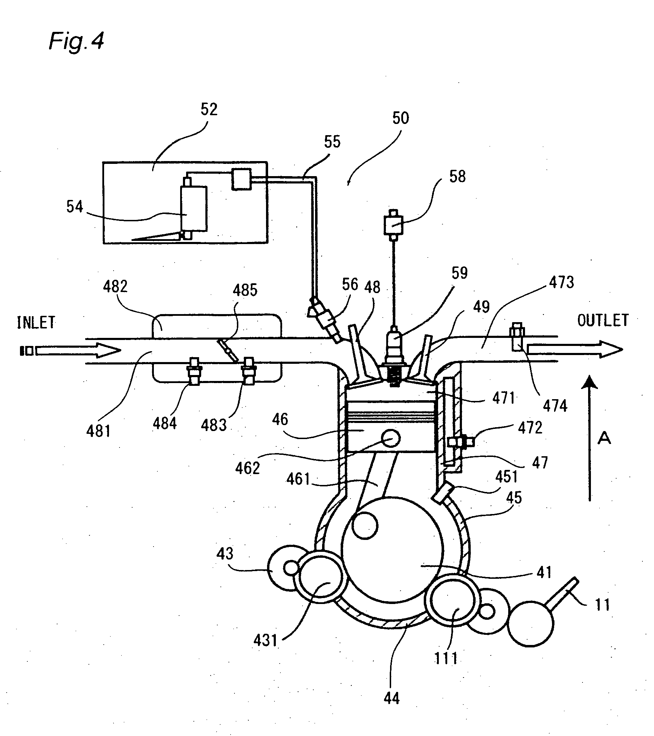

FIG. 4 is a schematic view of the engine 44 and the engine control system 50.

The engine control system 50 controls the driving of the engine 44. The engine control system 50 includes a fuel tank 52, an engine drive member embodied by a fuel pump 54, an injector 56, an ignition coil 58 and a spark plug 59.

The fuel tank 52 contains fuel, such as gasoline.

The fuel pump 54 is contained within the fuel tank 52. The fuel pump 54 is electrically driven. The fuel pump 54 applies pressure to fuel in the fuel tank 52 and discharges fuel to the injector 56. The fuel pump 54 includes a filter for removing impurities from fuel in the fuel tank 52 when it flows into it.

Alternatively, the fuel pump 54 may be disposed outside the fuel tank 52. In such an implementation, a hose is provided to connect the fuel tank 52 with the fuel pump 54.

The injector 56 supplies an amount of fuel as needed for the engine 44. The injector 56 is connected with the fuel pump 54 via the fuel hose 55. The injector 56 is electrically driven, and is electronically controlled by an engine control unit 60, described below. A plurality of holes are provided on the tip of the injector 56, and fuel is supplied to the engine 44 through these holes.

The ignition coil 58 causes the spark plug 59 to spark at required times. The ignition coil 58 includes a primary coil and a secondary coil that is disposed coaxially with the primary coil. In the ignition coil 58, a primary current flows through the primary coil, and shutting off the primary current induces electricity in the secondary coil such that the voltage is increased.

The engine 44 includes a crankshaft 41, a starter motor 43, a crank case 45, a piston 46, a cylinder 47, an inlet valve 48 and an outlet valve 49.

The crankshaft 41 transmits power generated by the engine 44. The crankshaft 41 converts a reciprocating motion of the piston 46 into a rotational motion. The crankshaft 41 extends in the direction perpendicular to the paper of FIG. 4. The crankshaft 41 is connected with the kick pedal 11 (see FIG. 1) via a gear mechanism 111. When the kick pedal 11 is depressed, power in the kick pedal 11 is transmitted to the crankshaft 41 via the gear mechanism 111 to rotate the crankshaft 41. Thus, the engine 44 is started.

The starter motor 43 is rotated as it is supplied with electric power following an operation of the starter button 35. The starter motor 43 is connected with the crankshaft 41 via the gear 431. When the starter button 35 is pushed and the starter motor 43 is rotated, the crankshaft 41 is rotated. The motorcycle 10 provides two methods of starting: starting the engine by means of the kick pedal 11, and starting the engine 44 by means of the starter motor 43. Arrangements for transmitting power from the starter motor 43 to the crankshaft 41 or arrangements for transmitting power from the kick pedal 11 to the crankshaft 41 are not limited to the arrangements of the present embodiment. For example, the number of gears in the gear mechanism for transmitting power from the kick pedal 11 to the crankshaft 41 or the position of the starter button 35 may be different from those for the present embodiment. The present invention requires a fuel pump 54; the engine 44 may be started only by the method using the kick pedal 11, or may be started only by the method using the starter motor 43.

The crank case 45 contains the crankshaft 41 in its interior. A crank angle sensor 451 for determining the angle of the crankshaft 41 is attached to the crank case 45.

The piston 46 is connected with the crankshaft 41 via the con rod 461. The piston 46 can be moved in a reciprocal manner within the cylinder 47. The piston 46 is connected with the con rod 461 via a piston pin 462.

The cylinder 47 is attached to the crank case 45. The cylinder 47 guides the movement of the piston 46. The combustion chamber 471 is formed by the cylinder 47 and the piston 46 at the one of the ends of the cylinder 47 suggested by the arrow A. An engine temperature sensor 472 for sensing the temperature in the engine 44 is attached to the cylinder 47. A plurality of holes are provided on the one of the ends of the cylinder 47 suggested by the arrow A. The cylinder 47 is connected with the inlet port 481 and the outlet port 473 via the one of the ends suggested by the arrow A. An oxygen sensor 474 is provided on the outlet port 473. A throttle body 482 is provided on the inlet port 481. The throttle body 482 includes an inlet air pressure sensor 483, an inlet air temperature sensor 484 and a throttle valve 485.

The inlet valve 48 is driven when mixed air is to be introduced into the combustion chamber 471. The inlet valve 48 is disposed on holes on the end of the cylinder 47.

The outlet valve 49 is driven when combustion gas is to be discharged from the combustion chamber 471. The outlet valve 49 is smaller than the inlet valve 48. The outlet valve 49 is disposed on holes on the end of the cylinder 47.

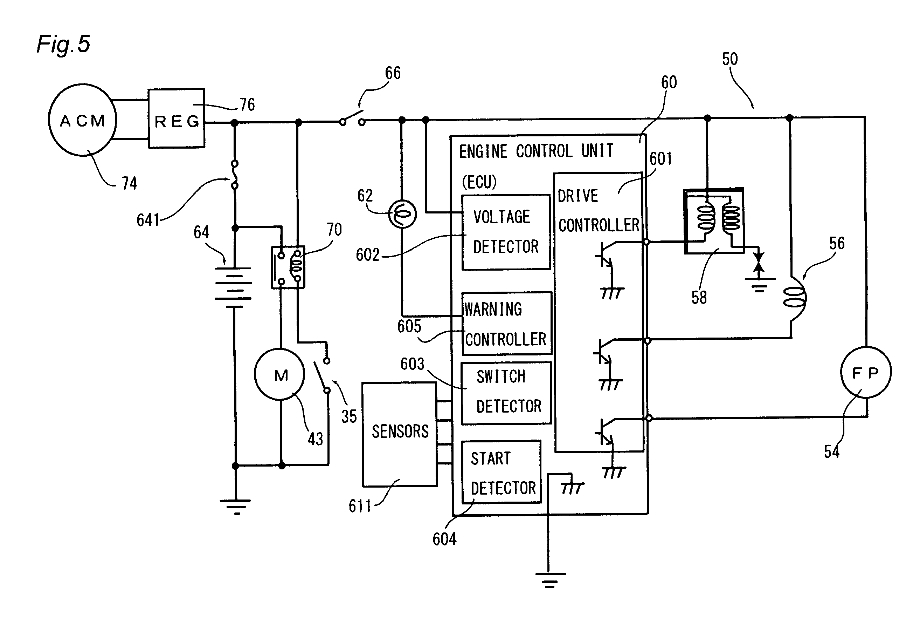

FIG. 5 is a circuit diagram of the engine control system 50.

The fuel pump 54 and the injector 56 included in the engine control system 50 are connected with the engine control unit 60 (hereinafter referred to as "ECU 60"). The warning lamp 62 and multiple sensors 611 are connected with the ECU 60. The multiple sensors 611 include, for example, the inlet air pressure sensor 483 and the inlet air temperature sensor 484 (see FIG. 4). A battery 64 for supplying the ECU 60 and other units with electric power is connected with the ECU 60 via a main switch 66. The battery 64 is a lead storage battery. A starter motor 43, a relay 70, a start button 35, a power generator 74 and a regulator 76 are connected with the battery 64. The main switch 66 may be switched between on and off by means of the ignition key.

The ECU 60 acquires information from the multiple sensors 611 and controls the driving of the engine 44 and other units. The ECU 60 has a drive controller 601, a voltage detector 602, a switch detector 603, a start detector 604 and a warning controller 605.

The drive controller 601 controls the power supply to the fuel pump 54, injector 56 and ignition coil 58.

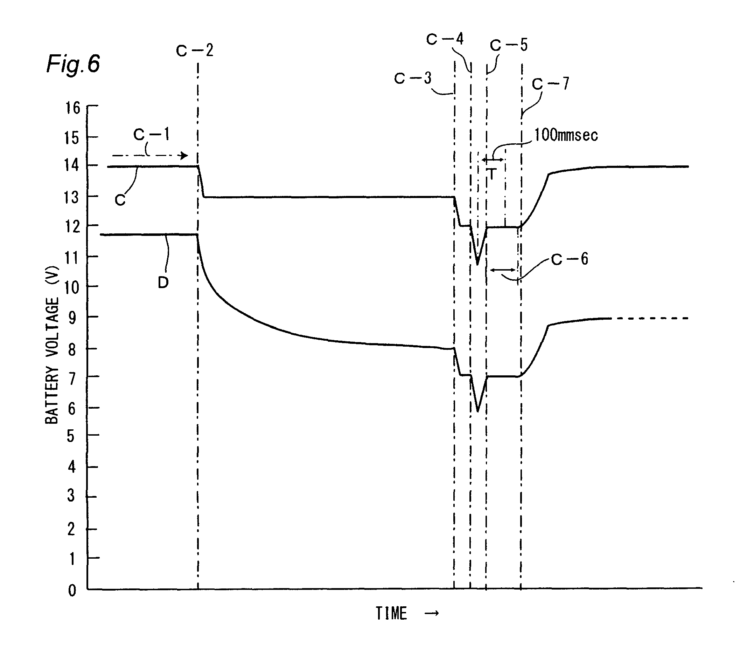

The voltage detector 602 senses the voltage at the battery 64. The timing of sensing of battery voltage by the voltage detector 602 will be described with reference to FIG. 6.

FIG. 6 illustrates changes in battery voltage during a run, a stop and a start of the motorcycle 10. The solid line C of FIG. 6 illustrates changes in battery voltage with a battery 64 that is sufficiently charged and has not deteriorated. The solid line D of FIG. 6 illustrates changes in battery voltage with a battery 64 that has deteriorated. The motorcycle 10 runs during interval C-1 of FIG. 6. The motorcycle 10 stops at time C-2. At time C-3, the ECU 60 is supplied with electric power from the battery 64 and starts. At time C-4, electric power begins to be supplied to the fuel pump 54. At time C-5, the driving of the fuel pump 54 stabilizes. During interval C-6, the driving of the fuel pump 54 is stabilized. At time C-7, the battery 64 begins to be charged by the driving of the engine 44, and continues to be charged since then.

When the engine 44 stops (C-2) while the motorcycle 10 is running (C-1), the battery voltage falls. When the main switch 66 turns on while the engine 44 is stopped, the ECU 60 starts (C-3). At this moment, as electric current flows into the ECU 60, the battery voltage falls. Thereafter, when the fuel pump 54 is started (C-4), the battery voltage falls significantly. This is due to the fact that the load current is larger when the fuel pump 54 is to be started than is the case when the ECU 60 is to be driven. Thereafter, from the time when the driving of the fuel pump 54 stabilizes (C-5), the battery voltage remains stabilized (C-6). In the present embodiment, the voltage detector 602 senses the battery voltage during this stabilization period (C-6). Specifically, a first period of time T from the start of the fuel pump 54 until the stabilization (C-6) (for example, 100 milliseconds in the present embodiment) is determined by experiment in advance, and the battery voltage 100 milliseconds after the start of the fuel pump 54 is determined. In the present embodiment, the battery voltage is sensed during the stabilization period; however, the present invention is not limited thereto, and the voltage may be sensed when the fuel pump 54 is started, for example. In the present invention, the battery voltage may be sensed after the fuel pump 54 is started (C-4) and before the fuel pump 54 stabilizes (C-5). In the present implementation, the battery voltage is sensed before the power generator 74 generates electric power, since it is difficult to sense the battery voltage after the power generator 74 begins to generate electric power.

Thereafter, the kick pedal 11 is depressed and the engine 44 starts. At this moment, the battery 64 is charged as the engine 44 is driven, and the battery voltage rises (C-7). When the battery voltage finishes rising, the battery voltage stabilizes.

Returning to FIG. 5, the description of the configuration of the ECU 60 will be resumed.

The switch detector 603 senses that the main switch 66 changes from off to on.

The start detector 604 detects a start of the engine 44. Specifically, the start detector 604 detects a start of the engine 44 based on information on the angle of the crankshaft 41 measured by the crank angle sensor 451.

The warning controller 605 provides the warning lamp 62 with a warning instruction when the voltage at the battery 64 sensed by the voltage detector 602 is at or below a predetermined warning threshold (a first threshold). In the present embodiment, the warning threshold is 9 volts. The warning controller 605 keeps the warning lamp 62 lighting up during a preset period of time (a third period of time). In the present embodiment, the warning controller 605 keeps the warning lamp 62 to light up for about 30 seconds, for example.

The warning controller 605 does not issue a warning instruction when the battery voltage sensed by the voltage detector 602 after a start of the engine 44 is detected is at or below the threshold. The warning controller 605 issues a warning instruction when the battery voltage sensed by the voltage detector 602 before a start of the engine 44 is detected is at or below the threshold even if the engine 44 starts thereafter.

The warning threshold, which is a reference used to determine whether the warning controller 605 should issue a warning instruction, is preset in the range of voltage values that do not allow the engine 44 to be started by means of the starter motor 43 and yet allow it to be started by means of the kick pedal 11. That is, the warning threshold is set within a range of the highest of voltage values that do not allow the engine 44 to be started by the starter motor 43, which provides the upper limit, to the lowest of voltage values that allow the engine to be started by the kick pedal 11, which provides the lower limit. The warning threshold is not limited thereto and may be set in the range of voltages that allow the engine to be started by means of the starter motor 43, for example, or may be in the range where there is the possibility that the engine 44 cannot be started by the kick pedal 11. Further, the user may set the range depending on the usage environment.

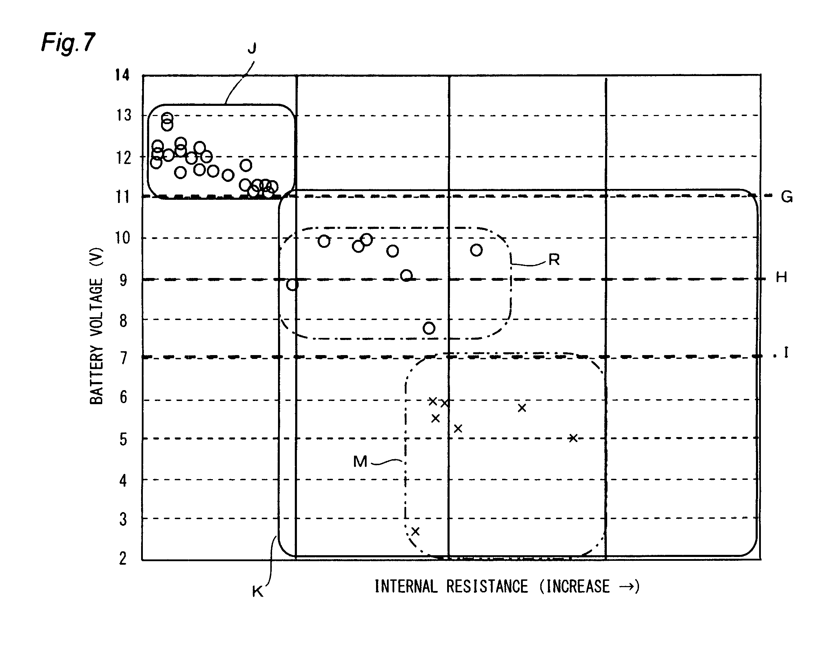

FIG. 7 shows results of experiments in which it was determined whether the engine was successfully started, produced in a particular experiment environment. In FIG. 7, "O" indicates an experiment result where the engine was successfully started, while "X" indicates an experiment result where the engine was not successfully started. In FIG. 7, the broken line G indicates the border between conditions where the engine 44 can be started by the starter motor 43 and conditions where it cannot be started. The engine 44 can be started by the starter motor 43 in conditions indicated above the broken line G. The broken line H indicates the warning threshold. A warning instruction is issued by the warning controller 605 in conditions indicated below the broken line H. The broken line I indicates the border between conditions where the engine 44 can be started by the kick pedal 11 and conditions where it cannot be started. The engine 44 cannot be started by the kick pedal 11 in conditions indicated below the broken line I. The frame J defines an area in which experiment results were obtained where the engine 44 was successfully started by the starter motor 43. The frame K defines an area where the battery 64 is over-discharged or has deteriorated. The one-dot chain line frame R defines an area in which experiment results were obtained where the engine 44 was not successfully started by the starter motor 43 but the engine 44 was successfully started by the kick pedal 11. The two-dot chain line frame M defines an area in which experiment results were obtained where the engine 44 was not successfully started by the starter motor 43 nor kick pedal 11.

As shown in FIG. 7, in conditions indicated in the area where the voltage sensed by the voltage detector 602 of the ECU 60 is 11 volts or higher, the engine 44 can be started both by the starter motor 43 and the kick pedal 11. In conditions indicated in the area where the voltage sensed by the voltage detector 602 of the ECU 60 is in the range of 7 to 11 volts, the engine 44 cannot be started by the starter motor 43, but the engine 44 can be started by the kick pedal 11. Although not shown in FIG. 7, in conditions indicated in the area where the voltage sensed by the voltage detector 602 of the ECU 60 is lower than 11 volts, the engine cannot be started by the starter motor 43. In conditions indicated in the area where the voltage sensed by the voltage detector 602 of the ECU 60 is lower than 7 volts, the engine 44 cannot be started by the starter motor 43 nor the kick pedal 11. Even with a battery that has been over-discharged or has deteriorated, the engine 44 can be started by the kick pedal 11 if the battery voltage is 7 volts or higher. The warning threshold is set to 9 volts so as to warn the user and encourage him to replace the battery before it is absolutely impossible to start the engine 44 by means of the kick pedal 11. Although the warning threshold is 9 volts in the present embodiment, the present invention is not limited thereto and the warning threshold may be other values than 9 volts, such as 8 volts, 9.5 volts or 11 volts.

Referring to FIG. 5, the arrangements around the ECU 60 will be described.

The warning lamp 62 receives a warning instruction from the warning controller 605 and lights up.

The battery 64 supplies the ECU 60 with electric power. When the engine 44 is to be driven, the battery 64 supplies electric power to the fuel pump 54, the injector 56 and the ignition coil 58 in response to instructions from the ECU 60. When the starter button 35 is pushed, the battery 64 supplies the starter motor 43 with electric power to drive the starter motor 43. A fuse 641 for short-circuit protection is attached in the vicinity of the battery 64.

The relay 70 has a coil and a switch. When electric current flows through the coil, the relay 70 becomes an electromagnet and draws the switch to turn the switch on.

The start button 35 switches between a state where electric power is supplied to the coil of the relay 70 from the battery 64, and a shutoff state.

The power generator 74 is attached to the crankshaft 41. The power generator 74 generates electric power using rotations of the crankshaft 41.

The regulator 76 optimizes the output voltage. The regulator 76 is connected with the power generator 74.

### <Operations>

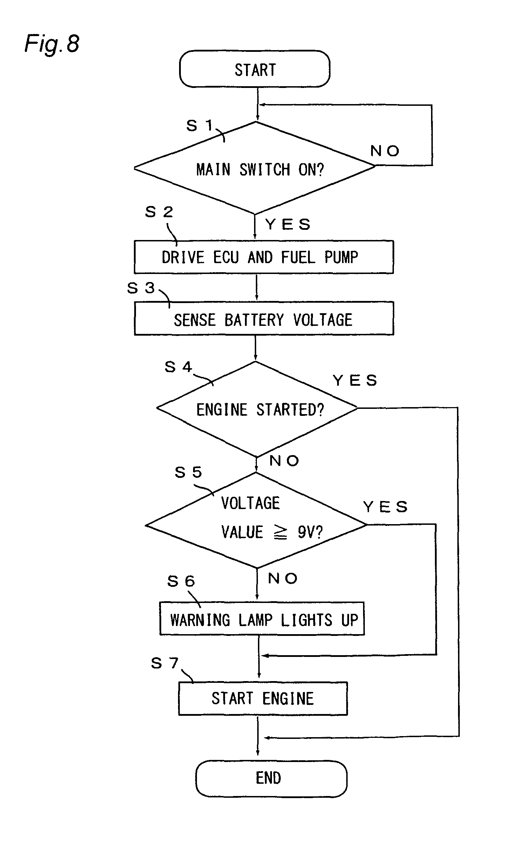

FIG. 8 is a flowchart illustrating a start operation for the engine 44. Referring to FIG. 8, an engine start operation will now be described.

The switch detector 603 determines whether the main switch 66 has changed from off to on by a turn of an ignition key (step S1). As the user inserts an ignition key into the insertion slot 33 and turns it, the main switch 66 changes from off to on. If the main switch 66 has not changed from off to on (NO in step S1), the process waits until the switch turns on. If the main switch 66 has changed from off to on (YES in step S1), electric power is supplied from the battery 64 to the ECU 60. Electric power is supplied from the battery 64 to the ECU 60 until the main switch 66 is turned off.

When electric power is supplied to the ECU 60, the drive controller 601 causes electric power to be supplied from the battery 64 to the fuel pump 54 (step S2). Electric power is continuously supplied from the battery 64 to the fuel pump 54. At this moment, the ECU 60 determines the battery voltage (step S3). It is determined whether the engine 44 has already started (step S4). If the engine 44 has already started (YES in step S4), the engine start operation is finished. If the engine 44 has started, a warning operation is not performed. Thus, it is possible to avoid sensing the battery voltage when the battery voltage rises as the engine 44 starts. If the engine 44 has not started (NO in step S4), it is determined whether the battery voltage is higher than 9 volts (step S5). If the battery voltage is higher than 9 volts (YES in step S5), the process advances to step S7. If the battery voltage is 9 volts or lower, (NO in step S5), the warning lamp 62 lights up (step S6). The warning lamp 62 continues to light up for about 30 seconds. Since the warning lamp 62 turns off after 30 seconds, the battery voltage may be prevented from falling due to the light-up of the warning lamp 62.

If the user now depresses the kick pedal 11 or pushes the starter button 35, the crankshaft 41 is rotated to start the engine 44 (step S7). The ECU 60 causes the battery 64 to supply electric power to the injector 56, and fuel is supplied from the injector 56 to the combustion chamber 471 at appropriate times. Thereafter, the ECU 60 causes the battery 64 to supply electric power to the ignition coil 58 and causes the spark plug 59 to spark at appropriate times. A spark at the spark plug 59 causes mixed air, made of air inside the combustion chamber 471 and fuel, to explode to rotate the crankshaft 41.

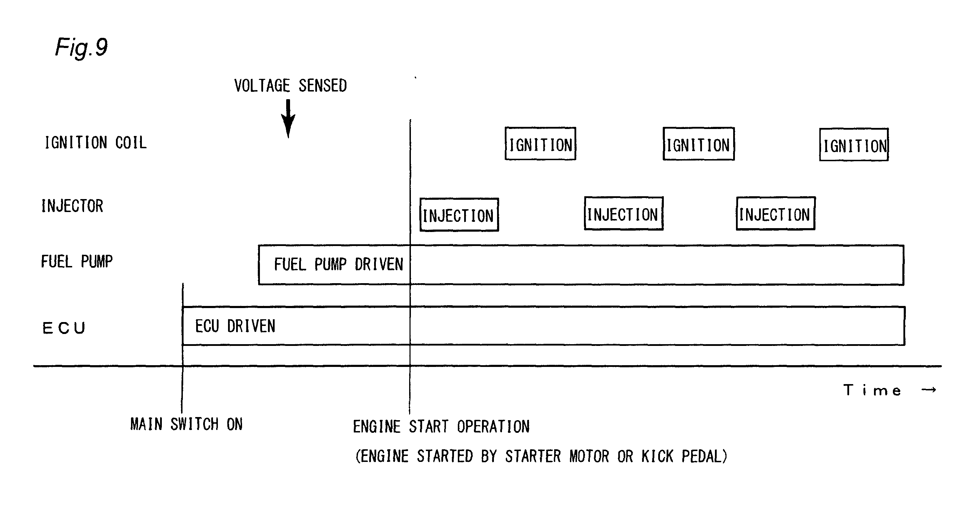

FIG. 9 is a timing chart illustrating the driving of the ECU and the engine control system 50. In FIG. 9, the horizontal axis represents the time. The boxes printed to the right of "ECU" and "FUEL PUMP" each indicate the time period during which they are supplied with electric power from the battery 64.

When the main switch 66 changes from off to on, electric power is supplied to the ECU 60. Thereafter, electric power is supplied to the fuel pump 54. Then, the battery voltage is sensed. That is, the operation of sensing the battery voltage is performed after the main switch 66 changes from off to on and before an engine start operation is performed. When an engine start operation is performed by starting the starter motor 43 or depressing the kick pedal 11, electric power is supplied to the injector 56. Fuel is supplied from the injector 56 to the combustion chamber 471. Thereafter, electric power is supplied to the ignition coil 58. The spark plug 59 ignites mixed air inside the combustion chamber 471. Thereafter, power supply and shutoff to the injector 56 and the ignition coil 58 are repeated.

### <Features of First Embodiment>

The features of the present embodiment will be described below.

In the above embodiment, a warning is issued depending on the battery voltage after electric power begins to be supplied to the fuel pump 54 included in the engine control system 50, making it possible to determine whether the engine 44 can be started without using a special detection part for determining whether the engine 44 can be started.

Further, in the above embodiment, it is determined whether the engine 44 can be started before the engine 44 is started, making it possible to determine whether the engine 44 can be started in a condition similar to that with a voltage value of the battery 64 found when the engine 44 is actually started, with the battery 64 not charged yet by the engine 44.

In the above embodiment, it is determined whether a warning should be issued based on a battery voltage value found after electric power begins to be supplied to the fuel pump 54, improving precision in sensing compared with a case where electric power is supplied to an arrangement separate from the engine control system 50 to determine the voltage value. In other words, in the above embodiment, electric power is supplied to the fuel pump 54, which has varying start loads depending on the environment around the motorcycle 10, making it possible to determine whether the engine 44 can be started taking into account the environment around the motorcycle 10.

In the above embodiment, the warning threshold is larger than battery voltage values found when the engine 44 cannot be started, making it possible to warn the user before the engine 44 cannot be started.

In the above embodiment, electric power is supplied from the battery 64 to the ECU 60 and fuel pump 54 and the battery voltage is sensed while the driving of the fuel pump 54 is stabilized, improving the precision in sensing the battery voltage.

In the above embodiment, the sensing of battery voltage is stopped when the start detector 604 detects a start of the engine 44, making it possible to avoid sensing the voltage when the battery voltage rises as the engine 44 starts.

In the above embodiment, the light-up time period of the warning lamp 62 is prescribed, making it possible to minimize the reduction in battery voltage due to light-up.

### [Second Embodiment]

In the first embodiment, the engine drive member is embodied by the fuel pump 54 and the operation of determining whether the engine 44 can be started includes the ECU 60 causing electric power to be supplied from the battery 64 to the fuel pump 54 after electric power begins to be supplied to the ECU 60; in a second embodiment, after electric power begins to be supplied to the ECU 60, the ECU 60 causes electric power to be supplied from the battery 64 to the fuel pump 54 and the ignition coil 58, and thus the engine drive member is embodied by the fuel pump 54 and the ignition coil 58. Except for this difference, the configuration of the second embodiment is the same as that of the first embodiment, and its description will be omitted.

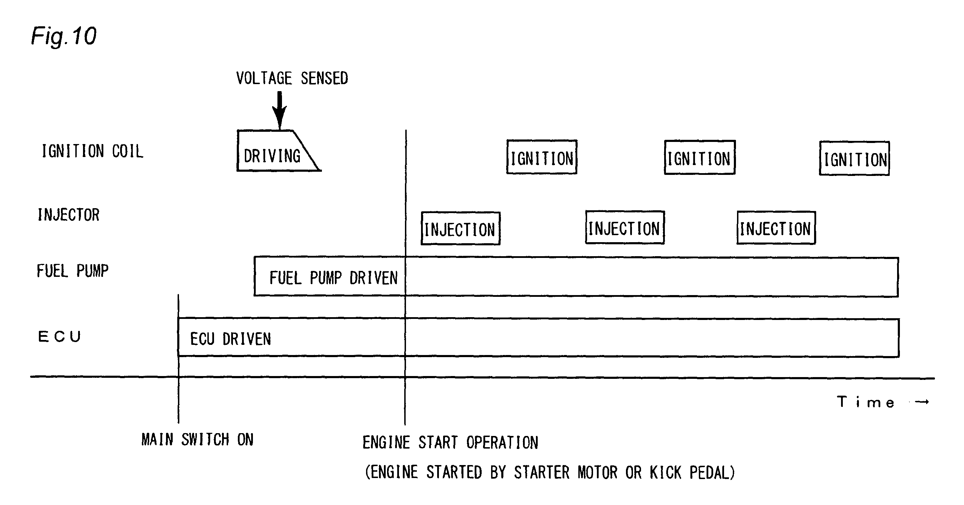

A start operation of the engine 44 is performed in accordance with the timing chart shown in FIG. 10. In FIG. 10, the horizontal axis represents the time. The boxes printed to the right of "ECU " and "FUEL PUMP" each indicate the time period during which they are supplied with electric power from the battery 64. The operation of sensing the battery voltage is performed after the main switch 66 changes from off to on and before an engine start operation is performed.

When the main switch 66 turns on, electric power is supplied from the battery 64 to the ECU 60. When supplied with electric power from the battery 64, the ECU 60 causes electric power to be supplied from the battery 64 to the fuel pump 54 and the ignition coil 58. After electric power begins to be supplied to the fuel pump 54 and the ignition coil 58 (specifically, 100 milliseconds after the fuel pump 54 is started, for example), the battery voltage is sensed. The warning lamp 62 lights up if the battery voltage value is smaller than a start enable value (i.e. a second threshold), which is a voltage that allows the engine 44 to be started, determined in advance by experiment.

After it is determined whether the engine 44 can be started, the supply of electric power from the battery 64 to the ignition coil 58 is shut off. At this moment, the power supply to the ignition coil 58 is decreased slowly, in other words, gradually and in a prolonged period of time, so as not to cause the spark plug 59 to spark.

Thereafter, when the engine 44 is started by the starter motor 43 or by the kick pedal 11, electric power is supplied to the injector 58 and fuel is supplied to the combustion chamber 471. After fuel is supplied to the combustion chamber 471, electric power is supplied to the ignition coil 58. The spark plug 59 ignites mixed air within the combustion chamber 471. Thereafter, power supply and shutoff to the injector 56 and the ignition coil 58 are repeated.

### <Features of Second Embodiment>

In the second embodiment, the battery voltage is sensed while electric power is being supplied from the battery 64 to the fuel pump 54 and the ignition coil 58 after electric power begins supplied from the battery 64 to the ECU 60 and before the engine 44 is started, such that it is determined whether the engine 44 can be started in a condition more similar to conditions in which the engine 44 is started. Thus, it can be determined more precisely whether the engine 44 can be started.

Further, the power supply to the ignition coil 58 is gradually shut off before the engine 44 is started, such that the spark plug 59 does not spark.

### [Other Embodiments]

While a motorcycle has been described in the above embodiments, the present invention is not limited thereto and can be used in a straddle type vehicle with three or four wheels.

### Explanation of Reference Characters

- 10: motorcycle (straddle type vehicle)
- 11: kick pedal
- 41: crankshaft
- 43: starter motor
- 44: engine
- 50: engine control system
- 52: fuel tank
- 54: fuel pump
- 56: injector
- 58: ignition coil
- 60: engine control unit (ECU) (controller)
- 62: warning lamp (warning unit)
- 64: battery
- 66: main switch
- 111: gear mechanism
- 601: drive controller
- 602: voltage detector
- 603: switch detector
- 604: start detector
- 605: warning controller

## Claims

1. A straddle type vehicle (10) comprising:
an engine(44);
an engine control system (50) that drives the engine (44);
a battery (64) that supplies electric power to the engine control system (50);
a main switch (66) that switches between a supply enable state in which electric power can be supplied from the battery (64) to the engine control system (50) and a shutoff state in which power supply from the battery (64) to the engine control system (50) is shut off;
a warning unit (62); and
a control unit (60),
the engine control system (50) including:
a fuel tank (52);
an engine drive member (54, 58) used for driving the engine(44); and
an injector (56) that supplies the fuel discharged by the engine drive member (54, 58) to the engine(44),
the engine (44) is started by performing a predetermined operation after electric power is supplied from the battery (64) to the engine control system (50),
the control unit (60) including:
a switch detector (603) that detects that the main switch (66) has changed from off to on;
a drive controller (601) that drives the engine drive member (54, 58) when the switch detector (603) detects that the main switch (66) has changed from off to on;
a start detector (604) that detects a start of the engine (44);
a voltage detector (602) that senses a voltage at the battery (64) after the engine drive member (54, 58) begins to be driven and before an engine start operation, in which electric power is supplied to the injector (56), is performed and the start detector (604) detects a start of the engine (44); and
a warning controller (605) that provides the warning unit (62) with a warning instruction if a voltage value sensed by the voltage detector (602) is not larger than predetermined threshold (H) after the engine drive member (54, 58) begins to be driven and before the engine start operation is performed and the start detector (604) detects a start of the engine (44).

2. The straddle type vehicle (10) according to claim 1, wherein the engine drive member (54) is a fuel pump (54) that applies pressure to fuel in the tank (52) and discharges the fuel therefrom.

3. The straddle type vehicle (10) according to claim 1 or 2, further comprising:
a gear mechanism (111) that transmits power to a crankshaft (41) provided on the engine (44); and
a kick pedal (11) connected with the gear mechanism (111).

4. The straddle type vehicle (10) according to claim 3, wherein the predetermined threshold (H) is a voltage value larger than a voltage value that is preset as a value that allows the engine (44) to be started by the kick pedal (11).

5. The straddle type vehicle(10) according to any one of claims 1 to 4, further comprising:
a starter motor (43) that rotates the crankshaft (41) when the starter motor (43) is supplied with electric power from the battery (64).

6. The straddle type vehicle (10) according to claim 5, wherein the predetermined threshold (H) is preset in a range of voltage values that do not allow the engine (44) to be started by the starter motor (43) but allow the engine (44) to be started by the kick pedal (11).

7. The straddle type vehicle (10) according to any one of claims 1 to 6, wherein the control unit (60) is supplied with electric power from the battery (64) when the main switch (66) changes from off to on.

8. The straddle type vehicle (10) according to claims 7, wherein the drive controller (601) controls a driving of the engine drive member (54, 58) after electric power begins to be supplied from the battery (64) to the control unit (60).

9. The straddle type vehicle (10) according to any one of claims 1 to 8, wherein the voltage detector (602) senses a voltage a first period of time after the engine drive member (54, 58) begins to be driven.

10. The straddle type vehicle (10) according to claim 9, wherein the first period of time is preset as a period of time that includes a period of time from a time when the engine drive member (54, 58) begins to be driven until current in the engine drive member (54, 58) stabilizes.

11. The straddle type vehicle (10) according to claim 1, wherein the engine drive member (54, 58) includes:
a fuel pump that applies pressure to fuel in the tank and discharges the fuel therefrom; and
an ignition coil (58) that is supplied with electric power from the battery (64).

12. The straddle type vehicle(10) according to claim 11, wherein the drive controller (601) begins to drive the ignition coil (58) at the same time at which the fuel pump (54) begins to be driven.

13. The straddle type vehicle (10) according to any one of claims 1 to 12, wherein the voltage detector (602) stops sensing a voltage if the start detector (604) detects a start of the engine (44).

14. The straddle type vehicle (10) according to any one of claims 1 to 13, wherein the warning unit (62) stops issuing a warning after a third period of time.

15. The straddle type vehicle (10) according to any one of claims 1 to 14, wherein the warning unit (62) is a warning lamp (62).

## Patentansprüche

1. Sattelfahrzeug (10), umfassend:
eine Motor (44);
ein Motorsteuersystem (50), das die Motor (44) ansteuert;
eine Batterie (64), die das Motorsteuersystem (50) mit elektrischem Strom versorgt;
einen Hauptschalter (66), der zwischen einem Versorgungsinkraftsetzzustand, in dem das Motorsteuersystem (50) mit elektrischem Strom aus der Batterie (64) versorgt werden kann, und einem Abschaltzustand umschaltet, in dem die Stromversorgung von der Batterie (64) zu dem Motorsteuersystem (50) abgeschaltet wird;
eine Warneinheit (62); und
eine Steuereinheit;
wobei das Motorsteuersystem (50) umfasst:
einen Brennstofftank (52);
ein Motorantriebselement (54, 58), das zum Antreiben der Motor (44) verwendet wird; und
einen Einspritzer (56), der den Brennstoff, der von dem Motorantriebselement (54, 58) abgegeben wird, der Motor (44) zuführt,
wobei die Motor (44) gestartet wird, indem eine vorbestimmte Tätigkeit ausgeführt wird, nachdem elektrischer Strom aus der Batterie (64) dem Motorsteuersystem (50) zugeführt wurde,
wobei die Steuereinheit (60) umfasst:
einen Schalterdetektor (603), der erfasst, dass der Hauptschalter (66) von AUS zu Ein gewechselt hat;
eine Antriebssteuereinheit (601), die das Motorantriebselement (54, 58) ansteuert, wenn der Schalterdetektor (603) erfasst, dass der Hauptschalter (66) von AUS zu EIN gewechselt hat;
einen Startdetektor (604), der einen Start der Motor (44) erfasst;
einen Spannungsdetektor (602), der eine Spannung an der Batterie (64) erfasst, nachdem das Motorantriebselement (54, 58) begonnen hat angetrieben zu werden und bevor ein Motorstartvorgang, bei dem elektrischer Strom dem Einspritzer (56) zugeführt wird, ausgeführt wird und der Startdetektor (604) einen Start der Motor (44) erfasst; und
eine Warnsteuereinheit (605), die die Warneinheit (62) mit einer Warnanweisung versorgt, sofern ein Spannungswert, der von dem Spannungsdetektor (602) erfasst wird, nicht größer ist als ein vorbestimmter Schwellenwert (H), nachdem das Motorantriebselement (54, 58) begonnen hat angetrieben zu werden und bevor der Motorstartvorgang ausgeführt wird und der Startdetektor (604) einen Start der Motor (44) erfasst.

2. Sattelfahrzeug (10) nach Anspruch 1, bei dem das Motorantriebselement (54) eine Brennstoffpumpe (54) ist, die auf den Brennstoff in dem Tank (52) Druck ausübt und den Brennstoff aus diesem abgibt.

3. Sattelfahrzeug (10) nach Anspruch 1 oder 2, weiterhin umfassend:
einen Getriebemechanismus (111), der Kraft auf eine Kurbelwelle (41) ausübt, die an der Motor (44) vorgesehen ist; und
ein Trittpedal (11), das mit dem Getriebemechanismus (111) verbunden ist.

4. Sattelfahrzeug (10) nach Anspruch 3, bei dem der vorbestimmte Schwellenwert (H) ein Spannungswert ist, der größer ist als ein Spannungswert, der als ein Wert voreingestellt ist, der es der Motor (44) gestattet, durch das Trittpedal (11) gestartet zu werden.

5. Sattelfahrzeug (10) nach einem der Ansprüche 1 bis 4, weiterhin umfassend:
einen Anlassermotor (43), der die Kurbelwelle (41) dreht, wenn der Anlassermotor (43) mit elektrischem Strom aus der Batterie (64) versorgt wird.

6. Sattelfahrzeug (10) nach Anspruch 5, bei dem der vorbestimmte Schwellenwert (H) in einem Bereich von Spannungswerten voreingestellt ist, die es der Motor (44) nicht gestatten, von dem Anlassermotor (43) gestartet zu werden, es jedoch der Motor (44) gestatten, durch das Trittpedal (11) gestartet zu werden.

7. Sattelfahrzeug (10) nach einem der Ansprüche 1 bis 6, bei der die Steuereinheit (60) mit elektrischem Strom aus der Batterie (64) versorgt wird, wenn der Hauptschalter (66) von AUS zu EIN wechselt.

8. Sattelfahrzeug (10) nach Anspruch 7, bei dem die Antriebssteuereinheit (601) einen Antrieb des Motorantriebselementes (54, 58) steuert, nachdem begonnen wurde, elektrischen Strom aus der Batterie (64) der Steuereinheit (60) zuzuführen.

9. Sattelfahrzeug (10) nach einem der Ansprüche 1 bis 8, bei dem der Spannungsdetektor (602) eine Spannung einer ersten Zeitperiode erfasst, nachdem das Motorantriebselement (54, 58) begonnen hat angetrieben zu werden.

10. Sattelfahrzeug (10) nach Anspruch 9, bei dem die erste Zeitperiode als eine Zeitperiode voreingestellt ist, die eine Zeitperiode ab einer Zeit umfasst, ab der das Motorantriebselement (54, 58) beginnt, angetrieben zu werden, bis sich der Strom in dem Motorantriebselement (54, 58) stabilisiert.

11. Sattelfahrzeug (10) nach Anspruch 1, bei dem das Motorantriebselement (54, 58) umfasst:
eine Brennstoffpumpe, die auf Brennstoff in dem Tank Druck ausübt und den Brennstoff aus diesem abgibt, und
eine Zündspule (58), die mit elektrischem Strom aus der Batterie (64) versorgt wird.

12. Sattelfahrzeug (10) nach Anspruch 11, bei dem die Antriebssteuereinheit (601) beginnt, die Zündspule (58) zu derselben Zeit anzusteuern, zu der die Brennstoffpumpe (54) beginnt, angetrieben zu werden.

13. Sattelfahrzeug (10) nach einem der Ansprüche 1 bis 12, bei dem der Spannungsdetektor (602) das Erfassen einer Spannung stoppt, sofern der Startdetektor (604) einen Start der Motor (44) erfasst.

14. Sattelfahrzeug (10) nach einem der Ansprüche 1 bis 13, bei dem die Warneinheit (62) das Ausgeben einer Warnung nach einer dritten Zeitperiode stoppt.

15. Sattelfahrzeug (10) nach einem der Ansprüche 1 bis 14, bei der die Warneinheit (62) eine Warnlampe (62) ist.

## Revendications

1. Véhicule de type à enfourcher (10), comprenant :
un moteur (44) ;
un système de contrôle du moteur (50) qui commande le moteur (44) ;
une batterie (64) qui alimente en puissance électrique le système de contrôle du moteur (50) ;
un interrupteur principal (66) qui commute entre un état d'habilitation d'alimentation dans lequel de la puissance électrique peut être alimentée par la batterie (64) au système de contrôle du moteur (50) et un état de coupure dans lequel l'alimentation à partir de la batterie (64) du système de contrôle du moteur (50) est coupée ;
une unité d'avertissement (62) ; et
une unité de contrôle (60),
le système de contrôle du moteur (50) comprenant :
un réservoir de carburant (52) ;
un élément de commande du moteur (54, 58) utilisé pour commander le moteur (44) ; et
un injecteur (56) qui alimente le carburant déchargé par l'élément de commande du moteur (54, 58) au moteur (44),
le moteur (44) étant démarré en mettant en oeuvre une opération prédéterminée après l'alimentation d'une puissance électrique à partir de la batterie (64) au système de contrôle du moteur (50),
l'unité de contrôle (60) comprenant :
un détecteur d'interrupteur (603) qui détecte qui l'interrupteur principal (66) a changé d'un état d'arrêt à un état de marche ;
un contrôleur de commande (601) qui commande l'élément de commande du moteur (54, 58) quand le détecteur d'interrupteur (603) détecte que l'interrupteur principal (66) a changé d'un état d'arrêt à un état de marche ;
un détecteur de démarrage (604) qui détecte un démarrage du moteur (44) ;
un détecteur de tension (602) qui détecte une tension sur la batterie (64) après que l'élément de commande du moteur (54, 58) commence à être commandé et avant qu'une opération de démarrage du moteur, dans laquelle une puissance électrique est alimentée à l'injecteur (56), est mise en oeuvre et que le détecteur de démarrage (604) détecte un démarrage du moteur (44) ; et
un contrôleur d'avertissement (605) qui procure à l'unité d'avertissement (62) une instruction d'avertissement si une valeur de tension détectée par le détecteur de tension (602) n'est pas supérieure au seuil prédéterminé (H) après que l'élément de commande du moteur (54, 58) commence à être commandé, et avant que l'opération de démarrage du moteur est mise en oeuvre et que le détecteur de démarrage (604) détecte un démarrage du moteur (44).

2. Véhicule de type à enfourcher (10) selon la revendication 1, dans lequel l'élément de commande du moteur (54) est une pompe à carburant (54) qui applique de la pression au carburant dans le réservoir (52) et décharge le carburant depuis celui-ci.

3. Véhicule de type à enfourcher (10) selon la revendication 1 ou 2, comprenant en outre :
un mécanisme d'engrenage (111) qui transmet de la puissance à un vilebrequin (41) pourvu sur le moteur (44) ; et
une pédale de démarrage (11) connectée au mécanisme d'engrenage (111).

4. Véhicule de type à enfourcher (10) selon la revendication 3, dans lequel le seuil prédéterminé (H) est une valeur de tension supérieure à une valeur de tension qui est préétablie comme une valeur permettant de démarrer le moteur (44) à l'aide de la pédale de démarrage (11).

5. Véhicule de type à enfourcher (10) selon l'une quelconque des revendications 1 à 4, comprenant en outre :
un moteur de démarreur (43) qui fait tourner le vilebrequin (41) quand le moteur de démarreur (43) est alimenté en puissance électrique depuis la batterie (64).

6. Véhicule de type à enfourcher (10) selon la revendication 5, dans lequel le seuil prédéterminé (H) est une valeur préétablie dans une plage de valeurs de tension qui ne permettent pas de démarrer le moteur (44) à l'aide du moteur de démarreur (43) mais permettent de démarrer le moteur (44) à l'aide de la pédale de démarrage (11).

7. Véhicule de type à enfourcher (10) selon l'une quelconque des revendications 1 à 6, dans lequel l'unité de contrôle (60) est alimentée en puissance électrique à partir de la batterie (64) quand l'interrupteur principal (66) passe de l'état d'arrêt à l'état de marche.

8. Véhicule de type à enfourcher (10) selon la revendication 7, dans lequel le contrôleur de commande (601) contrôle une commande de l'élément de commande du moteur (54, 58) après qu'une puissance électrique commence à être alimentée depuis la batterie (64) à l'unité de contrôle (60).

9. Véhicule de type à enfourcher (10) selon l'une quelconque des revendications 1 à 8, dans lequel le détecteur de tension (602) détecte une tension durant une première période après que l'élément de commande du moteur (54, 58) commence à être commandé.

10. Véhicule de type à enfourcher (10) selon la revendication 9, dans lequel la première période est préétablie comme une période qui comprend une période à partir d'un moment où l'élément de commande du moteur (54, 58) commence à être commandé jusqu'à ce que le courant dans l'élément de commande du moteur (54, 58) se stabilise.

11. Véhicule de type à enfourcher (10) selon la revendication 1, dans lequel l'élément de commande du moteur (54, 58) comprend :
une pompe à carburant qui applique de la pression au carburant dans le réservoir et décharge le carburant depuis celui-ci ; et
une bobine d'allumage (58) qui est alimentée en puissance électrique par la batterie (64).

12. Véhicule de type à enfourcher (10) selon la revendication 11, dans lequel le contrôleur de commande (601) commence à commander la bobine d'allumage (58) au moment où la pompe à carburant (54) commence à être commandée.

13. Véhicule de type à enfourcher (10) selon l'une quelconque des revendications 1 à 12, dans lequel le détecteur de tension (602) arrête de détecter une tension si le détecteur de démarrage (604) détecte un démarrage du moteur (44).

14. Véhicule de type à enfourcher (10) selon l'une quelconque des revendications 1 à 13, dans lequel l'unité d'avertissement (62) arrête d'émettre un avertissement après une troisième période.

15. Véhicule de type à enfourcher (10) selon l'une quelconque des revendications 1 à 14, dans lequel l'unité d'avertissement (62) est une lampe d'avertissement (62).
